# EUROPÄISCHE PATENTANMELDUNG

(11) **EP 1 873 844 A1**
(43) Veröffentlichungstag der Anmeldung: **02.01.2008**
(21) Anmeldenummer: 06114838.3
(22) Anmeldetag: 01.06.2006
(51) Int. Cl.: H01L 31/18

(54) **Vorrichtung zur Photovoltaikzellenverarbeitung**

(71) Anmelder: KIOTO Clear Energy AG, 9020 Klagenfurt (AT)
(72) Erfinder: Napetschnig, Georg, 9103 Diex (AT)
(74) Vertreter: Staudt, Armin Walter

(57) **Zusammenfassung**

Die erfindungsgemäße Vorrichtung betrifft eine Fertigungsstraße (1) zur automatisierten Verarbeitung einzelner Photovoltaikzellen (11) zum Herstellen von Strings (17), bei der die einzelnen Photovoltaikzellen (11) mittels eines Sauggreifers (10) von einem Vorratsmagazin (3) abgenommen und einer Zentriereinheit zugeführt werden, anschließend eine Löteinrichtung (15) durchlaufen, wo sie mit gekröpften, elektrisch leitenden Metallverbindern (8) in einer Serienschaltung miteinander verbunden werden und von einem Stringabnehmer (16) die fertigen Strings (17) aus der Fertigungsstraße (1) ausgetragen werden. Sie zeichnet sich dadurch aus, dass sie unterschiedlich große und unterschiedlich Dicke Photovoltaikzellen (11) verarbeiten kann und der Transport durch die Fertigungsstraße ausschließlich mittels Vakuum erfolgt.

## Beschreibung

Die vorliegende Erfindung betrifft eine Vorrichtung zur Photovoltaikzellenverarbeitung zur Herstellung von Solarmodulen. Es zeichnet sich dadurch aus, dass es geeignet ist zur Verarbeitung von Photovoltaikzellen unterschiedlicher Schichtstärken und unterschiedlicher Größen.

Es gibt Photovoltaikzellen in unterschiedlichsten Größen und mit unterschiedlichsten Dicken der kristallinen Siliziumschicht auf dem Wafer als Trägersubstanz. Gängige Photovoltaikzellen liegen derzeit als rechteckige oder quadratische, dünne Platten mit einer Seitenlänge von 50 mm bis 200 mm und einer Dicke der kristallinen Siliziumschicht von 300 µm bis 160 µm vor. Künftige Entwicklungen gehen offenkundig in die Richtung noch größere Platten mit noch geringeren Dicken zu erzeugen.

Die derzeit bekannten automatisierten Vorrichtungen zur Verarbeitung von Photovoltaikzellen sind jeweils nur auf einen bestimmten Photovoltaikzellentyp ausgelegt und können daher nicht flexibel genug auf die neuen Entwicklungen auf diesem Sektor reagieren. Zudem sind automatische Fertigungsstraßen mit einem hohen Investitionsaufwand verbunden, weswegen sie nur bei langer Standzeit mit entsprechend hohen Produktzahlen wirtschaftlich einsetzbar sind.

Zusätzlich weisen sie das Problem auf, dass die Photovoltaikzellen sehr anfällig für mechanische Beschädigungen, beispielsweise durch Greifer, Positionierungsanschläge, Wender und dergleichen sind.

Bei der Verarbeitung einzelner Photovoltaikzellen werden diese mit elektrisch leitenden Verbindern zu sogenannten Strings zusammengeschaltet, die die Spannung der einzelnen Photovoltaikzellen durch Reihenschaltung auf ein nutzbares Niveau anheben und auch wieder untereinander verschaltet werden.

Bei der Verbindung von beispielsweise 5 bis 10 einzelnen Photovoltaikzellen in einem String werden nach dem Stand der Technik kurze, elektrisch leitende Lötstreifen auf den Photovoltaikzellen, auf denen schon ein kamm- oder gitterartiges Raster von Kontaktbahnen aufgedruckt ist, dauerhaft angebracht. Dies geschieht üblicherweise durch Löten. Da die Kontaktpunkte oder Kontaktflächen der einzelnen Photovoltaikzellen an verschiedenen Stellen der unterschiedlichen Photovoltaikzellentypen auftreten, ist es für eine automatisierte Vorrichtung notwendig, in möglichst einfacher Art und Weise die Verbindungsleiter an diese Kontaktstellen heranzuführen. Hierzu ist eine exakte Positionierung der Teile, insbesondere der Photovoltaikzellen notwendig, die selbst aber Fertigungstoleranzen aufweisen können.

Da gleichzeitig hohe Taktraten erreicht werden sollen, um eine möglichst große Zahl von Strings in möglichst geringer Zeit herzustellen, werden die Photovoltaikzellen bisher mit einiger Geschwindigkeit an Anschläge heran bewegt. Diese Anschläge sind meist aus dauerhaftem Material, beispielsweise aus Stahl, damit die scharfen Siliziumkanten diese Anschläge nicht zu schnell abschleifen. Photovoltaikzellen sind aber sehr bruchanfällig, sodass das Anschlagsmaterial oft zu Kantenbruch oder im schlimmsten Fall zu Haarrissen in der Photovoltaikzelle führt. Da gleichzeitig die fertigen Strings zu Modulpaketen zusammengefasst zwischen Glasplatten oder ähnlich dauerhafte, gegen die Umwelt schützende Kapselungen eingebracht werden, können schadhafte Photovoltaikzellen nachträglich nicht mehr ausgetauscht werden. Der Einbau schon einer fehlerhaften Photovoltaikzelle macht daher ein großes, aufwendig hergestelltes Modul unbrauchbar.

Um bei der exakten Positionierung der Photovoltaikzellen solche Probleme zu vermeiden werden in bekannten Vorrichtungen die einzelnen Photovoltaikzellen mittels einer Saugeinrichtung von einem Vorratsmagazin abgehoben und auf der Zentriereinrichtung meist mittels einer optoelektronischen Positionskontrolle exakt positioniert, bevor sie dem Lötplatz zugeführt werden, wobei die reproduzierbar genau vorgegebene spätere Lage der auftransportierten Verbinder als Bezugspunkt dient. Die Verbinder, werden dabei an der Vorder- und der Rückseite der Photovoltaikzelle durch Löten aufgebracht, wobei sie zuvor mit einer Lötpaste mittels Lötpastendispenser oder mit Flussmittel mittels Düsen beaufschlagt und anschließend gewendet werden, damit überschüssiges Löthilfsmittel, welches bei der späteren Einkapselung der Strings zu Problemen führen würde, dadurch wieder entfernt wird, dass die Verbinder mechanisch gewendet werden.

Die eingesetzten Verbinder sind nur wenige Zentimeter lang und 1 bis 2 mm breit. Sie werden nach dem Stand der Technik zunächst von oben an der späteren Unterseite mit Löthilfsmittel beaufschlagt, dann gewendet und in einer Transporteinrichtung mit Unterdruck gehalten und in dieser Stellung zum Lötplatz verbracht. Der eigentliche Lötvorgang mittels eines Lötstrahlers erfolgt dann durch ein Aufheizen der gesamten Photovoltaikzelle mit aufgelegtem Verbinder auf eine Temperatur, bei der die Lötpaste aufschmilzt. Durch ein Hubbalkensystem, das mit einer Riementransporteinrichtung kombiniert ist, wird dann der wachsende String aus dem Lötbereich herausgefahren und gelangen danach mittels eines Saughebers auf einen Stringablagetisch.

Eine andere Literaturstelle beschreibt ein Verfahren und eine Vorrichtung zum Herstellen von Solarmodulen, bei dem ebenfalls die Photovoltaikzellen mit nach unten weisenden Sonnenseiten den Bearbeitungsvorgängen unterworfen werden. Durch die Anordnung mit nach unten weisender Sonnenseite wird ein späteres Wenden des fertigen Strings vermieden. Dabei werden die Photovoltaikzellen durch einen Saugträger von einem Magazinstapel abgezogen, einer Prüfstelle zugeleitet und anschließend in Reihe angeordnet zur Auflötung eines elektrisch leitenden Verbindungsstreifens. Dieser wird abgekröpft geführt und ist mit seiner ersten Halblänge an der nach oben liegenden Rückseite der Photovoltaikzelle und seiner zweiten Halbseite an der nach unten liegenden Sonnenseite der nachfolgenden Photovoltaikzelle aufgelötet. Zwischen benachbarten Photovoltaikzellen befindet sich ein kleiner Spalt. Der Verbindungsstreifen weist hier eine Breite von 3 mm und eine Dicke von 0,2 mm auf. Die verlöteten Strings werden mittels eines weiteren Saugförderers auf einen als Schrittschaltträger dienenden Kettenbandförderer nacheinander mit nach unten gerichteter Sonnenseite aufgelegt und die die beiden stirnseitigen Enden der Strings derselben überragenden Lötanschlüsse auf dem Kettenbandförderer durch Löten miteinander verbunden. Anstelle des Kettenbandförderers kann hier auch eine Platte od. dgl. vorgesehen sein.

Zur weiteren Verarbeitung werden die miteinander verbundenen, sich über einen Teilbereich oder den gesamten Bereich des Kettenbandförderers erstreckenden Strings durch einen weiteren Saugförderer vom Kettenbandförderer abgehoben und zwischen mit Glasscheiben kaschierten EVA Folien eingelegt. Das solcherart gebildete Glasscheiben-, Folien- und Stringpaket wird übereinander geschichtet einem Heizofen zum sandwichartigen Verbacken der Folien zugeführt. Es versteht sich, dass bei der Übertragung der miteinander verlöteten Strings mittels Abhebe- und Verschiebebewegungen der Saugförderers nur geringe mechanische Kräfte an den Photovoltaikzellen wirksam werden, die mechanische Beschädigungen ausschließen.

All diese bekannten Systeme weisen jedoch den entscheidenden Nachteil auf, dass die Gesamtstringlängen einen vorgegebenen Toleranzbereich von unter 1 mm überschreiten können. Beim Transport der einzelnen Photovoltaikzellen zur Löteinrichtung, durch sie hindurch und dem nachfolgenden Austrag der Strings kann es zu geringfügigen Verschiebungen kommen, welche durch die Temperaturführung noch begünstigt wird. Zudem weisen die Photovoltaikzellen selbst eine Größentoleranz von +/- 0,5 mm auf.

Ein weiterer erheblicher Nachteil bekannter Einrichtungen zur Herstellung der Photovoltaikzellenstrings besteht darin, dass sie nur auf eine bestimmte Photovoltaikzellen-Plattengröße ausgelegt sind und bei einer Änderung der Photovoltaikzellen-Plattengröße - sofern überhaupt möglich - nur mit sehr hohem technischen Aufwand umgerüstet werden können.

Ähnlich problematisch verhalten sich bekannte Einrichtungen bei einer Reduktion der Photovoltaikzellen-Plattendicke. Aus ökonomischen Gründen werden zunehmend dünnere Photovoltaikzellenplatten entwickelt, deren Einsatz in den bekannten vollautomatischen Anlagen der erfindungsgemäßen Gattung jedoch nicht mit befriedigenden Ergebnissen eingesetzt werden können, da solche dünnen Platten die dort auftretenden mechanischen Beanspruchungen zumeist nicht aushalten und es in Folge zu überhöhten Bruchraten kommt.

Um diese Nachteile des bekannten Standes der Technik zu vermeiden, stellt sich die vorliegende Erfindung die Aufgabe, eine Vorrichtung zur automatisierten Photovoltaikzellenverarbeitung zur Herstellung von Photovoltaikzellenstrings zu schaffen, bei welcher die Gesamtstringlänge des hergestellten Photovoltaikzellenstrings einen vorgegebenen Toleranzbereich von 1 mm oder weniger nicht überschreitet und welche geeignet ist zur Verarbeitung von Photovoltaikzellen unterschiedlicher Flächenmaße und unterschiedlicher Dicken.

Diese Aufgabe wird durch eine Vorrichtung gelöst, welche die technischen Merkmale von Anspruch 1 aufweist. Vorteilhafte Weiterentwicklungen sind Gegenstand der abhängigen Ansprüche.

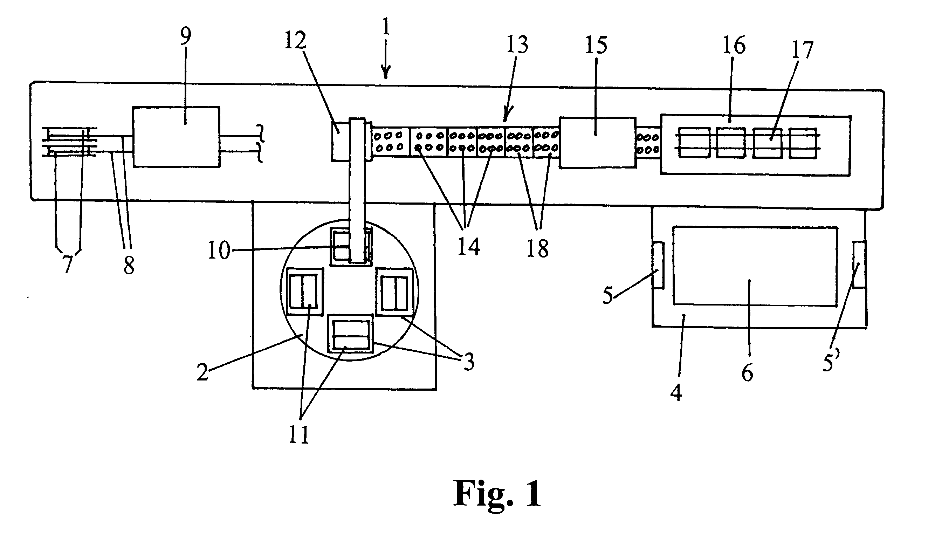

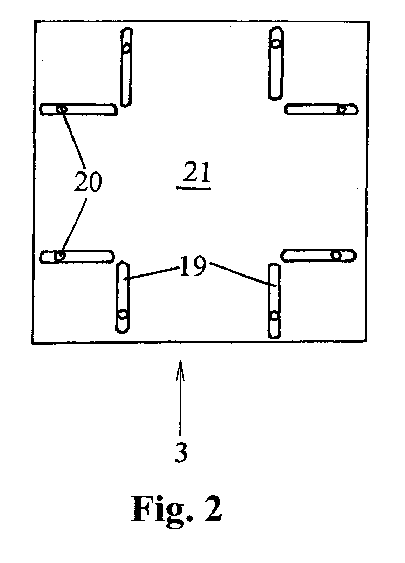

Eine mögliche Ausführungsform der Erfindung wird anhand der Figuren näher erläutert. Darin zeigt Figur 1 den schematischen Aufbau der erfindungsgemäßen Vorrichtung. Figur 2 zeigt in Detailansicht das Magazin zur Aufnahme der Photovoltaikzellen.

Die erfindungsgemäße Vorrichtung, dargestellt in Figur 1, besteht aus einer im wesentlichen linearen Fertigungsstraße 1, einem seitlich angebauten Drehtisch 2 mit mehreren Magazinen 3 und einem seitlich angebauten Aufnahmetisch 4 für die fertigen Photovoltaikzellenstrings mit Prüfungseinrichtungen 5 und 6. Von den Vorratsrollen 7 werden elektrisch leitende Metallverbinder 8 abgenommen, mit einem Löthilfsmittel beaufschlagt und in einer Trocknungseinrichtung 9 vorbehandelt. Durch die Trocknung des Löthilfsmittels vor der Lötstation wird verhindert, dass beim Kontakt der Metallverbinder 8 mit der Photovoltaikzelle durch seitlich austretendes Löthilfsmittel deren Oberfläche negativ beeinflusst wird.

Ein Sauggreifer 10 nimmt einzelne Photovoltaikzellen 11 aus einem der Magazine 3 auf, wobei die Sonnenseite der Photovoltaikzelle 11 stets nach oben ausgerichtet ist und befördert diese zu einer Zentriereinheit. Dort wird die Photovoltaikzelle 11 nach einer ihrer Außenkanten und/oder nach dem Verlauf eines Strom-Sammelbalkens des Kollektors ausgerichtet. Die Photovoltaikzelle 11 wird anschließend von einem Ganzflächenvakuumplattensauger 12 aufgenommen und auf einem Förderband 13 abgelegt. Das Förderband 13 besteht aus einer Kette von auf einem Träger aufliegenden Kunststoffplatten 18, welche bevorzugt aus Teflon gefertigt sind oder eine Teflonoberfläche besitzen und weist in Förderbandlängsrichtung mindestens eine, bevorzugt jedoch zwei oder mehr Reihen von lochförmigen Durchbrüchen 14 auf, die mit einer Vakuumeinrichtung in Wirkverbindung stehen und durch welche die aufgelegten Photovoltaikzellen 11 mittels Unterdruck gehalten und durch die Löteinrichtung 15 bis zum Stringabnehmer 16 befördert werden. Der Stringabnehmer 16, ebenfalls ein Saugförderer, hebt die fertigen Strings 17 vom Förderband 13 ab und legt sie auf der Prüfstation 4 ab, wo sie durch die Prüfungseinrichtung 5, 5' auf Leitfähigkeit bzw. Lötfehler und/oder durch die Prüfeinrichtung 6 auf Bruchstellen oder Haarrisse geprüft wird. Je nach Prüfergebnis wird der String 17 dann in verschiedenen Zwischenspeichern zur Weiterverarbeitung oder Ausschleusung abgelegt oder der Modulfertigung zugeführt. Die einander folgenden Photovoltaikzellen 11 sind mit abgekröpften Metallverbindern 8 verbunden.

Das Magazin 3 besteht aus einer Basisplatte 21, welche mit acht Durchbrüchen 19 ausgestattet ist, wobei jeweils zwei Durchbrüche 19 im Eckbereich einer Photovoltaikzelle 11 positioniert sind. In den Durchbrüchen sind Haltebolzen 20 lösbar und innerhalb der Durchbrüche verschiebbar befestigt. Je nach Größe der Photovoltaikzellen 11 werden die Haltebolzen 20 innerhalb der Durchbrüche 19 positioniert. Dabei sind die Durchbrüche 19 so bemessen, dass Photovoltaikzellen 11 mit einer Flächengröße von 150 x 150 mm bis 300 x 300 mm im Magazin 3 aufgenommen werden können.

Durch die spezielle Ausgestaltung der Magazine 3 und die Verwendung des Ganzflächenvakuumplattensaugers 12 ist es möglich, mit geringem Rüstaufwand Photovoltaikzellen 11 unterschiedlicher Größe auf derselben Fertigungsstraße 1 zu verarbeiten. Ein weiterer Vorteil liegt im Transport der Photovoltaikzellen 11 mit der Sonnenseite nach oben, da hierdurch die von optischen Sensoren unterstützte Zentrierung einfach ausgebildet werden kann. Die Zentrierung mittels optischer Sensoren verhindert dabei eine Beschädigung der Photovoltaikzellenkante während des Zentrierungsvorganges und unterstützt gleichzeitig die Verarbeitung unterschiedlicher Photovoltaikzellen auf derselben Fertigungsstraße 1.

Die fertigen Strings werden von einem mit Vakuum arbeitenden Stringabnehmer 16 von der Fertigungsstraße 1 abgehoben und um 180° um ihre Längsachse gedreht, um dann von einem zweiten, gleichartigen Stringabnehmer übernommen und auf dem Aufnahmetisch 4 abgelegt zu werden. Diese Manipulation ist durch den Einsatz von mit Vakuum arbeitenden Stringabnehmern 16 für den beschädigungsanfälligen String völlig problemlos möglich.

Durch die spezielle Ausführung des Förderbandes 13 mit Durchbrüchen 14 und einer damit in Wirkverbindung stehenden Vakuumanlage wird einerseits zuverlässig verhindert, dass die Photovoltaikzellen 11 während des Transportes durch die Fertigungsstraße 1 ihre Positionierung zueinander verändern können, andererseits wird auch dadurch die Verarbeitung von Photovoltaikzellen unterschiedlicher Größe ermöglicht.

Da sowohl die einzelnen Photovoltaikzellen 11 als auch der wachsende bzw. der fertige String ausschließlich mit Hilfe von Transporteinrichtungen bewegt werden die ihre Haltefunktion nur mittels Vakuum ausüben, ist es auch möglich, Photovoltaikzellen 11 mit geringerer Dicke als derzeit üblich zu verarbeiten.

## Patentansprüche

1. Vorrichtung zur automatisierten Verarbeitung einzelner Photovoltaikzellen (11) zum Herstellen von Strings (17), bei der die einzelnen, eine Sonnenseite aufweisenden, Photovoltaikzellen (11) mittels eines Sauggreifers (10) von einem Vorratsmagazin (3) abgenommen und einer Zentriereinheit zugeführt werden, anschließend eine Löteinrichtung (15) durchlaufen, wo sie mit elektrisch leitenden Metallverbindern (8) in einer Serienschaltung miteinander verbunden werden und von einem Stringabnehmer (16) die fertigen Strings (17) aus der Fertigungsstraße (1) ausgetragen werden, **dadurch gekennzeichnet, dass** die Photovoltaikzellen (11) vom Sauggreifer (10) erfasst und auf der mit optischen Sensoren versehenen Zentriereinheit aufgelegt werden, wobei die Zentrierung nach der Außenkante der Photovoltaikzelle (11) oder nach dem Verlauf eines auf der Sonnenseite der Photovoltaikzelle (11) aufgebrachten Sammelbalkens eines Kollektors erfolgt, dass ein Ganzflächenvakuumplattensauger (12) die Photovoltaikzellen (11) von der Zentriereinheit abnimmt und auf einem Förderband (13) ablegt, welches mit Durchbrüchen (14) versehen ist und mit einer Vakuumanlage in Wirkverbindung steht, und dass das Förderband (13) die Photovoltaikzellen (11) bzw. den wachsenden String (17) durch die restliche Fertigungsstraße (1) transportiert bis zur Abnahme des Strings (17) durch den mit Vakuum arbeitenden Stringabnehmer (16).

2. Vorrichtung nach Anspruch 1, **dadurch gekennzeichnet, dass** das Förderband (13) aus nebeneinander angeordneten, auf einem Träger zu einem umlaufenden Band miteinander verbundenen Kunststoffplatten (18) besteht, welche bevorzugt eine Oberfläche aus Teflon aufweisen, wobei die Kunststoffplatten (18) in Förderbandlängsrichtung angeordnet mindestens einen, bevorzugt jedoch zwei oder mehr zueinander parallele Streifen von lochförmigen Durchbrüchen (14) aufweisen, die mit einer Vakuumeinrichtung in Wirkverbindung stehen und durch welche die aufgelegten Photovoltaikzellen (11) mittels Unterdruck festgehalten und bis zum Stringabnehmer (16) befördert werden.

3. Vorrichtung nach Anspruch 1 oder 2, **dadurch gekennzeichnet, dass** das Magazin (3) für die Vorlage der zu verarbeitenden Photovoltaikzellen (11) in einer Lochführung (19) stufenlos verschiebbare Haltestifte (20) besitzt, welche die Photovoltaikzellen (11) unverrückbar im Magazin (3) halten und welche durch Verschieben in ihrer Lochführung (19) auf die individuelle Größe unterschiedlich großer Photovoltaikzellen (11) einstellbar sind.

4. Vorrichtung nach Anspruch 1, 2 oder 3, **dadurch gekennzeichnet, dass** die zu verarbeitenden Photovoltaikzellen (11) eine Plattengröße von 150 x 150 mm bis 300 x 300 mm aufweisen.

5. Vorrichtung nach Anspruch 1, 2, 3 oder 4, **dadurch gekennzeichnet, dass** die zu verarbeitenden Photovoltaikzellen (11) eine Plattendicke von 240 µm bis 100 µm aufweisen.

6. Vorrichtung nach einem der Ansprüche 1 bis 5, **dadurch gekennzeichnet, dass** Einrichtungen für zwei oder mehr zueinander parallel verlaufende Metallverbinder (8) vorgesehen sind.

7. Vorrichtung nach einem der Ansprüche 1 bis 6, **dadurch gekennzeichnet, dass** jedem Metallverbinder (8) zwei Durchlaufrollen oder Flussmitteldüsen zum Aufbringen von Flussmittel auf der Ober- und Unterseite der Metallverbinder (8) zugeordnet sind.

8. Vorrichtung nach einem der Ansprüche 1 bis 7, **dadurch gekennzeichnet, dass** die Aufbringung des Flussmittels jeweils nur auf der zu verlötenden Seite der Metallverbinder (8) erfolgt.

9. Vorrichtung nach einem der Ansprüche 1 bis 8, **dadurch gekennzeichnet, dass** der Metallverbinder (8) nach dem Aufbringen des Flussmittels einer Einrichtung (9) zur Trocknung des Flussmittels zugeführt wird.

10. Vorrichtung nach einem der Ansprüche 1 bis 9, **dadurch gekennzeichnet, dass** vor und nach der Löteinrichtung (15) Einrichtungen zum gezielten Temperieren der Photovoltaikzelle (11) vorgesehen sind.

11. Vorrichtung nach einem der Ansprüche 1 bis 10, **dadurch gekennzeichnet, dass** der Stringabnehmer (16) den fertigen String (17) mittels Vakuum vom Förderband (13) abhebt und auf einem Aufnahmetisch (4) ablegt, welcher mit elektrischen Prüfeinrichtungen (5, 5') zur Messung der Leitfähigkeit und/oder einer optischen Prüfeinrichtung (6) zur Feststellung von Brüchen oder Haarrissen ausgestattet ist.

12. Vorrichtung nach einem der Ansprüche 1 bis 11, **dadurch gekennzeichnet, dass** der Stringabnehmer (16) den fertigen String (17) mittels Vakuum vom Förderband (13) abhebt und um 180° dreht, bevor der String (17) von einem gleichartigen zweiten Stringabnehmer erfasst und auf dem Aufnahmetisch (4) ablegt wird.

13. Vorrichtung nach einem der Ansprüche 1 bis 12, **dadurch gekennzeichnet, dass** die Photovoltaikzellen (11) mit der Sonnenseite nach oben vom Sauggreifer (10) erfasst werden.
